# EUROPEAN PATENT APPLICATION

(11) **EP 1 123 769 A2**
(43) Date of publication of application: **16.08.2001**
(21) Application number: 00310544.2
(22) Date of filing: 28.11.2000
(51) Int. Cl.: B23K 9/12, B25J 13/08

(54) **Robot welding**

(30) Priority: 11.02.2000 KR 2000006488
(71) Applicant: SAMSUNG ELECTRONICS CO., LTD., Suwon-City, Kyungki-do (KR)
(72) Inventor: Hong, Sung-jin, Seoul (KR)
(74) Representative: Geary, Stuart Lloyd

(57) **Abstract**

A preprogrammed weld path (P) for a teachable welding robot (5a, 5b, 21) is updated to take account of different workpiece configurations. Touch sensors (7a, 7b, 11, 205), preferably employing the welding wire (11) provided to the welding tools (5a, 5b), are used to sense the configuration of a workpiece (30) so that the welding path can be corrected to account for any difference between the workpiece's configuration and that of the workpiece used for treaching the path (P).

## Description

The present invention relates to a method of welding using a robot, the method comprising teaching a welding path to a robot, said path being defined by the co-ordinates of at least one point through which said path passes with a workpiece in a reference position, and mounting a workpiece in jig means associated with the robot. The present invention also relates to a robotic welding system comprising a welding robot, including control means and a welding tool, which can be taught a welding path, said path being defined by the co-ordinates of at least one point through which said path passes for a workpiece in a reference position, jig means associated with the robot for fixing the position of a workpiece, and touch sensing means.

Arc welding is widely used in industry for welding sheet steel and other materials, and its principles are well-known.

The use of arc-welding robots is known and in such systems a supply voltage, a distance between a welding torch and a workpiece, a supply speed for then welding wire, a speed for the welding torch, an initial welding point and a termination welding point are programmed into the welding robot system to achieve the desired weld and quality of weld.

For high quality welding, the position of the workpiece must be accurately established before the start of the welding operation. However, errors may arise with positioning devices such as positioners or welding jigs, or from the workpiece itself. Because of these errors, it is not easy for the welding robot to be operated exactly on a desired welding point. Various tracking techniques have been developed in order to track an exact path on the workpiece. The tracking techniques include arc sensor tracking, laser sensor tracking and touch sensor tracking. Arc sensor tracking uses an arc sensor to correct for displacement of the workpiece in real time when performing a weaving operation for the workpiece to be welded. Laser sensor tracking processes image data for the workpiece obtained by means of a laser vision camera, in order to correct for displacement of the workpiece in real time. Touch sensor tracking is used to detect an initial welding point when the workpiece is displaced. The displacement of the workpiece can be corrected in real time by using any of the above-mentioned tracking techniques as necessary.

Arc sensor tracking does not need any additional equipment. However, the software is expensive. The laser sensor tracking is the most typical tracking method. It has high-performance but requires high-cost additional equipment such as special laser sensors. In addition, in laser sensor tracking, a variety of sensors and devices need to be attached close to the welding torch installed at the end of a welding robot's arm, thereby resulting in a narrowing of the space for the welding operation. A main controller which is generally realized by a computer system performs the operations of monitoring and sampling a variety of data. Therefore, as the additional equipment increases in number, the likelihood of causing an error in the course of operating the system increases. Furthermore, the maintenance and repair of the additional equipment are highly complicated.

KR-A-98-27370 discloses a method of detecting an initial welding point and a termination welding point by means of touch sensor tracking after roughly setting up the type of a contact shape formed between workpieces and the initial welding point and the terminating welding point.

KR-A-98-83281 discloses a method of detecting an exact initial welding point by means of a touch sensor tracking.

Touch sensor tracking is a method of directly detecting the position of a workpiece by generating an interrupt from a controller when a welding wire, supplied to one end of a welding torch and which is positive (+), contacts the workpiece which is negative (-). However, touch sensor tracking requires a separate tracking mechanism for tracking a welding path to perform the welding operation along the welding path from the initial welding point even though the initial and terminating welding points are detected by touch sensor tracking. That is, additional equipment such as laser vision sensors, etc. is required, for which the touch sensor tracking has not solved the problems in relation to cost and welding space.

A method according to the present invention is characterised by using touch sensing means to establish the displacement of the workpiece relative to said reference position, modifying said path in dependence on the displacement, and welding the workpiece using a welding tool of the robot following the modified path.

Preferably, the robot is an arc-welding robot having an arc-welding tool and a welding wire feeding apparatus, and the touch sensing means comprises welding wire at the welding tool and supplied from the welding wire feeding apparatus.

A robotic welding system according to the present invention is characterised in that the control means is configured to operate the touch sensing means to establish the displacement of a workpiece, fixed by said jig means, relative to said reference position, modify said path in dependence on the displacement and control the welding tool so that it follows the modified path for welding of the workpiece.

Preferably, the welding tool is an arc-welding tool and the touch sensing means comprises welding wire associated with said tool.

In the touch sensor tracking prior art described above, touch sensor tracking is only used to determine an initial welding point and/or a terminating welding point for a unit welding operation.

An embodiment of the present invention will now be described, by way of example, with reference to the accompanying drawings, in which:-
Figure 1 is a schematic view of a welding robot system employing a method according to the present invention;
Figure 2 is a control block diagram of the welding robot system of Figure 1;
Figure 3 is a view explaining touch sensing according to the present invention; Figure 4 and 5 are schematic views of a method for correcting teaching points for a welding robot, according to the present invention; and
Figure 6 is a control flow chart of a controller.

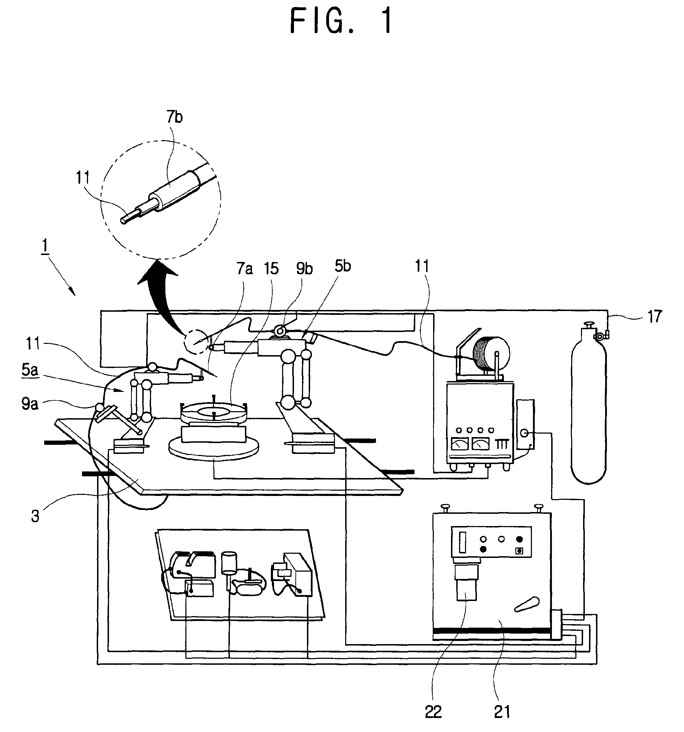

Referring to Figure 1, a welding robot system 1 comprises a pair of welding robots 5a, 5b installed opposite each other on a base stand 3, a pair of welding torches 7a, 7b supported by the welding robots 5a, 5b, a pair of wire feeders 9a, 9b supplying welding wire 11 to the welding torches 7a, 7b, a welding jig 15 provided between the welding robots 5a, 5b and supporting the workpiece to be welded, a gas feeder 17 supplying shielding gas to the welding torches 7a, 7b, and a controller 21 for controlling the operation of the welding robots 5a, 5b. The welding robots 5a, 5b are vertical six-shaft robots with respective driving motors. The welding robots 5a, 5b have header parts on their end parts which are movable in X, Y and Z directions, and the welding torches 7a, 7b are installed on the header parts. The welding torches 7a, 7b are supplied with the welding wires 11 from the wire feeders 9a, 9b, and the wires 11 protrude toward the centres of the end parts of the welding torches 7a, 7b.

The welding jig 15 supports the workpiece and then displaces it according to commands from the controller 21. The controller 21 is provided with a teaching pendant 22 for teaching welding parameters in conformity with characteristics of a welding operation. External electric power is supplied to the welding torches 7a, 7b according to commands from the controller 21 and the shielding gas is supplied from the gas feeder 17, and the arc is then generated and the arc welding is performed as the welding wire 11 starts to be melted.

It is preferable that a central processing unit (not shown) provided in the controller 21 is an 8086 series microprocessor.

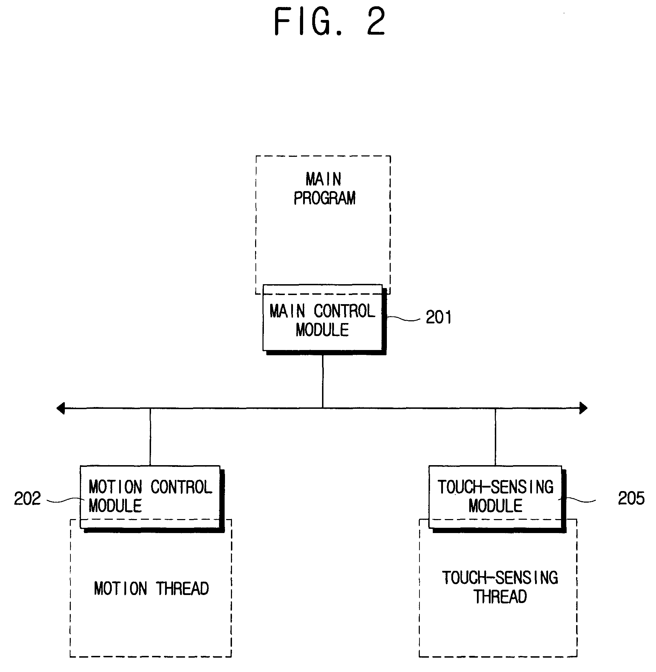

Referring to Figure 2, the controller 21 comprises a main control module 201 for generally controlling welding operations as appropriate for the workpiece, a motion control module 202 for controlling travel paths of the welding robots 5a, 5b and a touch sensing module 205 for touch-sensing the workpiece.

The controller 201 according to the present invention employs a real-time operating system enabling real-time multi-tasking, allowing a motion thread and a touch sensing thread to be run concurrently by the motion control module 202 and the touch sensing module 205, respectively. The motion thread is to control travel paths of the welding robots 5a, 5b whereas the touch sensing thread is to touch-sense the workpiece using the welding torches 7a, 7b. Here, the term "thread" refers to one of a group of tasks performed simultaneously through multi-tasking by time division.

The motion thread and the touch sensing thread independently performing their own tasks, but if necessary, they exchange data with each other by a main program performed by the main control module 201 or by generating interrupts between them.

A worker provides an appropriate main program according to the size and shape of the workpiece and a desired quality of welding, to perform a welding operation. The main program is a welding operation program executed by the main control module 201.

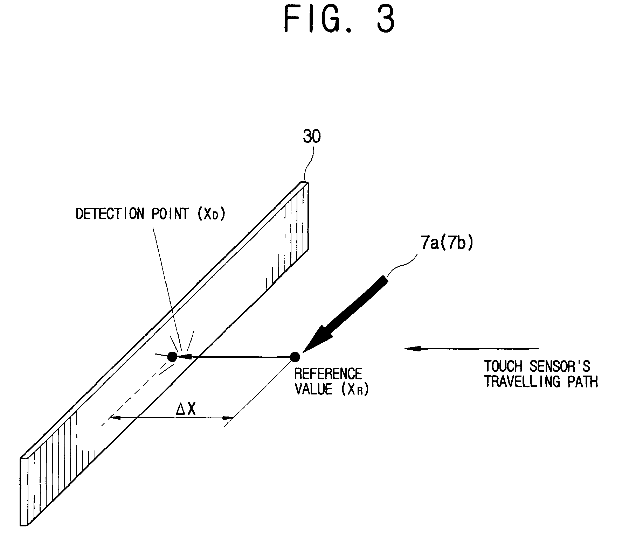

Referring to Figure 3, the touch sensing is performed basically in the same manner as in the touch sensing mechanism used in the conventional touch sensor tracking. That is, touch-sensing of the workpiece involves sensing a sensing position by an interrupt generated as the positive welding wire contacts the negative workpiece.

The touch sensing process will now be described in more detail.

The workpiece 30 is fixed on the welding jig 15 and then touch sensing is performed in accordance with predetermined reference values for preset detection points. The reference values include the directions of welding torches 7a, 7b relative to reference coordinate axes, the travelling directions of the welding torches 7a, 7b, and initial travelling and terminating travelling points for the welding torches 7a, 7b. The reference values could be represented by direction vectors to indicate the directions of the welding torches 7a, 7b relative to the reference coordinate axes and in vectors to indicate travelling directions and distances of the welding torches. For example, if a detection point (X_{D}) is located at the point which the travelling distance of the welding torch on the X axis exceeds the distance of _X over the reference value (X_{R}), it means that the workpiece is displaced as much as _X.

To use touch sensing, detection points are preferably set up appropriately according to the size and shape of the workpiece and the quality of welding, etc. In order to detect a spatial location, at least three detection points should be set up on the X, Y and Z axes respectively. However, it is not imperative. For example, if the workpiece is a standardized steel plate and a comparatively lower quality of welding is needed, only the height is needed to confirm whether the workpiece is correctly fixed.

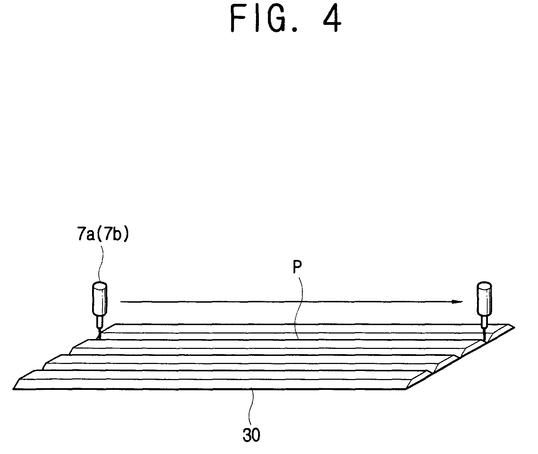

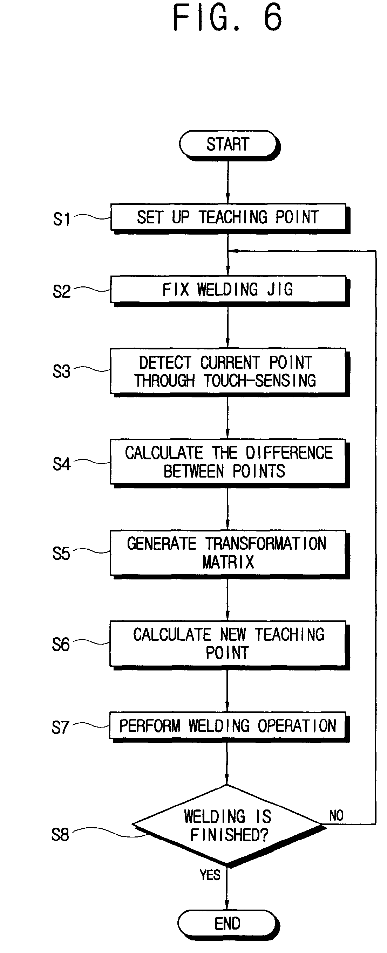

Hereinbelow, a method for correcting teaching points for a welding robot according to the present invention will be described with reference to Figures 4 to 6.

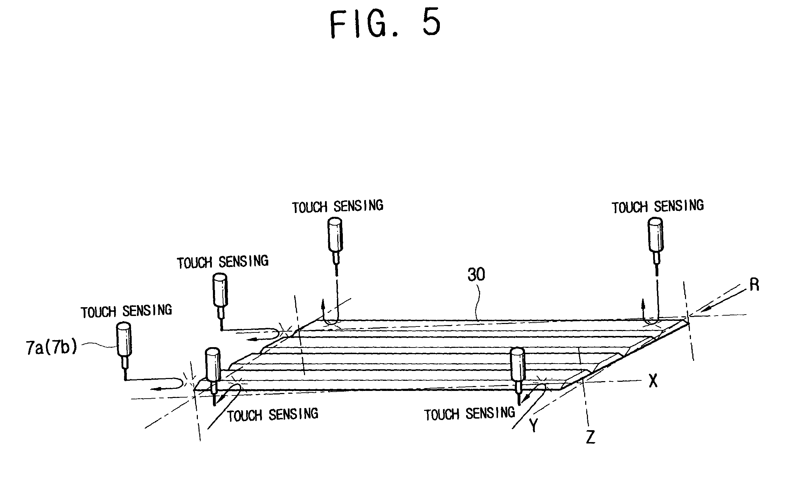

A worker chooses a main program appropriate for a welding operation for a workpiece to be welded, and establishes parameters for welding conditions and sets up the welding system, thereby allowing the main control module 210 to be executed. As depicted in Figure 4, in the course of setting up the welding system, N teaching points for the welding robot are established relative to the workpiece 30 to be welded, while moving the welding torches 7a, 7b along the welding path P where the workpiece 30 will be welded The teaching points are stored in the main control module 201 as space coordinates relative to the reference coordinate axes (S1). The space coordinates are, as shown in Figure 5, represented using a reference coordinate system based on three orthogonal axes (R) indicated by X, Y and Z. However, a cylindrical coordinate system or a polar coordinate system may be used for the reference coordinate system.

This process comprises establishing a reference coordinate system [W₀], and teaching N points #Pnt_1 - #Pnt_N.

When the teaching of the points has been completed, the correction of the teaching points along the taught welding path is initiated. For the correction operation, the workpiece 30 is first fixed by the welding jig 15 (S2). Next, a touch sensing operation is performed. The touch sensing operation is conducted by allowing the workpiece 30 to be touched by the welding wire 11 provided in the end part of a welding torch 7a, 7b (S3). The data to indicate points detected when the workpiece 30 and the wire 11 touch each other is transmitted to the motion thread activated by the motion control module 202, through an interrupt from the touch sensing thread. The motion thread calculates the detecting points based on the transmitted data to obtain point data relative to the reference coordinates and transmits them to the main control module 201.

The main control module 201 runs the main program to calculate the difference between the transmitted position data and the predetermined reference values (S4), and generates a transformation matrix on this basis (S5), and calculates new teaching points by multiplying the established teaching points by the transformation matrix (S6).

This process comprises:-
positioning the workpiece;
touch-sensor tracking relative to the reference coordinate axes X, Y and Z;
calculating Δx, Δy and Δz, the displacement of the workpiece through the touch sensor tracking;
generating the transformation matrix T^{N}₀ for transforming the displacement of the workpiece relative to the reference coordinate system [W₀];
calculating values for transformed points relative to the teaching points #Pnt_1 - #Pnt_N; and
transforming the teaching points to T^{N}₀×#Pnt_1, T^{N}₀×#Pnt_2, ... , T^{N}₀× #Pnt_N. The transformed teaching points replace the established teaching points and are stored as new teaching points. The main control module of the controller 21 drives the welding torches 7a and 7b according to the updated teaching points and performs the welding operation for the workpiece 30 (S7). When all the welding tasks are finished, the welding operation terminates (S8).

If all the welding tasks are not finished (S8), the processes from S2 through S7 will be repeated.

As described above, the teaching points are continuously updated every time a welding operation for a unit workpiece is performed. Accordingly, the welding robot system according to the present invention can be operated always with correct teaching points, thereby improving the precision of the welding path during the welding operation.

A method of correcting teaching points for welding of a workpiece such as a large pipe in the shipyard will now be explained.

Over one hundred different pipe forms may need to be welded. Conventionally, this requires the teaching points to be established over one hundred times, i.e. separately for each form of pipe, which is troublesome.

Employing the present invention, the teaching points for a first workpiece to be welded are corrected through touch tracking by a touch sensor provided in a welding robot, and thereafter, a welding operation is performed based on the corrected teaching points. Next, a second workpiece is positioned on the welding jig, and the displacement values of the second workpiece are calculated based on the teaching points of the first workpiece, and the teaching points are updated. The worker can conduct a welding operation with respect to the second workpiece different in shape by updating the teaching points, without establishing new teaching points.

It is also possible to classify the workpieces into several categories and then to perform the welding by category.

The correction method for teaching points according to the present invention is applicable to heavy industries such as for boilers or ships. Large workpieces such as boiler pipes are very voluminous and can become displaced although they are fixed by means of a welding jig or a big positioner. However, by employing the present invention, correct teaching points can be obtained by using a transformation matrix relative to the reference coordinate system initially set up, and the correct welding operation is possible accordingly.

As described above, according to a correction method of teaching points for a welding robot of the present invention, the teaching points are correctly updated by a touch sensor tracking without additional equipment for optional sensor tracking, such as laser sensors, arc sensors, etc., thereby performing the welding operation along the correct welding path.

## Claims

1. A method for correcting teaching points for a welding robot having a touch sensor, comprising the steps of:
mounting a workpiece to a welding jig;
establishing at least one teaching point between an initial welding point and a terminating welding point;
touch-sensing the workpiece at a point corresponding to the established teaching point through the touch sensor;
identifying a point detected by the touch-sensing; and
obtaining a new teaching point based on the difference between the established teaching point and the detection point.

2. The method according to claim 1, wherein the step of obtaining the new teaching point includes the sub-steps of:
generating a transformation matrix based on the difference between the established teaching point and the detection point; and
calculating the new teaching point by multiplying the established teaching point by the transformation matrix.

3. The method according to claim 1, wherein the touch sensor is comprised of a welding wire, provided at an end part of a welding torch.

4. The method according to claim 2, wherein the touch sensor is comprised of a welding wire, provided at an end part of a welding torch.

5. A welding robot system comprising a welding jig supporting a workpiece to be welded, a welding robot performing a welding operation to the workpiece and having a touch sensor, and a controller for controlling the welding robot, the controller identifying a point detected by touch-sensing the workpiece mounted to the welding jig through the touch sensor between an initial welding point and a terminating welding point, obtaining a new teaching point based on a difference between a preset teaching point and the detection point, and controlling the welding robot based the new teaching point.

6. The system according to claim 5, wherein the controller generates a transformation matrix based on the difference between the preset teaching point and the detection point, and calculates the new teaching point by multiplying the preset teaching point by the transformation matrix.

7. The system according to claim 5, wherein the touch sensor is comprised a welding wire, provided at an end part of the welding torch.

8. The system according to claim 6, wherein the touch sensor is comprised a welding wire, provided at an end part of the welding torch.

9. A method of welding using a robot, the method comprising:-
teaching a welding path (P) to a robot (5a, 5b, 21), said path being defined by the co-ordinates of at least one point through which said path passes with a workpiece in a reference position; and
mounting a workpiece (30) in jig means (15) associated with the robot,
**characterised by**
using touch sensing means (7a, 7b, 11, 205) to establish the displacement (Δx, Δy, Δz) of the workpiece (30) relative to said reference position;
modifying said path (P) in dependence on the displacement; and
welding the workpiece using a welding tool (5a, 5b) of the robot following the modified path.

10. A method according to claim 9, wherein the robot is an arc-welding robot having an arc-welding tool (5a, 5b) and a welding wire feeding apparatus (7a, 7b), and the touch sensing means comprises welding wire (11) at the welding tool (5a, 5b) and supplied from the welding wire feeding apparatus.

11. A robotic welding system comprising:-
a welding robot (5a, 5b, 21), including control means (21) and a welding tool (5a, 5b), which can be taught a welding path (P), said path (P) being defined by the co-ordinates of at least one point through which said path passes for a workpiece in a reference position;
jig means (15) associated with the robot for fixing the position of a workpiece; and
touch sensing means (7a, 7b, 11, 205),
**characterised in that** the control means (21) is configured to operate the touch sensing means to establish the displacement (Δx, Δy, Δz) of a workpiece (30), fixed by said jig means (15), relative to said reference position, modify said path in dependence on the displacement and control the welding tool (5, 5b) so that it follows the modified path for welding of the workpiece (30).

12. A system according to claim 10, wherein the welding tool (5a, 5b) is an arc-welding tool (5a, 5b) and the touch sensing means (7a, 7b, 11, 205) comprises welding wire (11) associated with said tool.
